# EUROPEAN PATENT SPECIFICATION

(11) **EP 4 693 362 B1**
(45) Date of publication and mention of the grant of the patent: **02.12.2026**
(21) Application number: 24193235.9
(22) Date of filing: 07.08.2024
(51) Int. Cl.: H01J 37/20

(54) **METHOD FOR PRODUCING A TEM GRID AND TEM GRID**
VERFAHREN ZUR HERSTELLUNG EINES TEM-GITTERS UND TEM-GITTER
PROCÉDÉ DE FABRICATION D'UNE GRILLE TEM ET GRILLE TEM

(43) Date of publication of application: 11.02.2026
(73) Proprietor: Forschungszentrum Jülich GmbH, 52425 Jülich (DE)
(72) Inventor: FALEY, Prof. Dr. Mikhail, 52428 Jülich (DE); GUNKEL, Dr. Felix, 50823 Köln (DE); THOMSEN, Dr. Joachim, 52072 Aachen (DE); TAVABI, Dr. Amir Hossein, 52428 Jülich (DE); DITTMANN, Dr. Regina, 52477 Alsdorf (DE); DUNIN-BORKOWSKI, Prof. Dr. Rafal Edward, 52428 Jülich (DE)
(74) Representative: Gille Hrabal Partnerschaftsgesellschaft mbB Patentanwälte

(56) References cited:
- US-A1- 2010 140 497
- N.N.: "GRIDS including TEM Support Films, Grid Staining, & Grid Storage", 20 March 2017 (2017-03-20), pages 1 - 55, XP093082867, Retrieved from the Internet <URL:http://scienceservices.de/media/pdf/ScienceServices_EMS_Catalogue_Grids.pdf> [retrieved on 20230918]
- RUIJUAN XU ET AL: "Highly confined epsilon-near-zero- and surface-phonon polaritons in SrTiO3 membranes", ARXIV.ORG, CORNELL UNIVERSITY LIBRARY, 201 OLIN LIBRARY CORNELL UNIVERSITY ITHACA, NY 14853, 13 March 2024 (2024-03-13), XP091699015
- BO HAN ET AL: "Direct observation of local antiferroelectricity induced phonon softening at a SrTiO3 defect", ARXIV.ORG, CORNELL UNIVERSITY LIBRARY, 201 OLIN LIBRARY CORNELL UNIVERSITY ITHACA, NY 14853, 3 March 2022 (2022-03-03), XP091176558

## Description

The invention refers to a method for producing a TEM grid and to a TEM grid. The invention also relates to the production of an electronic component that comprises the TEM grid. The invention also relates to all electronic components that are based on epitaxial films and devices fabricated on monocrystalline membranes.

A TEM grid, or Transmission Electron Microscopy grid, may comprise a membrane used to support samples that are to be examined under a Transmission Electron Microscope (TEM). Electrons can pass through the membrane. The membrane can provide a stable platform for the very thin samples required for transparency in electron beam and imaging.

The primary function of a TEM grid is to hold and stabilize the sample in the electron beam path, allowing the transmission of electrons through the sample for highresolution imaging and analysis with a spatial resolution down to atomic level.

The membrane can be attached to a substrate through which a hole passes. The substrate can be made of monocrystal silicon. The membrane can be made of polycrystalline silicon nitride. It is then possible to use KOH to etch a hole in the silicon that extends to the membrane. The reason for this is that the etching rate in the case of silicon is much higher than the etching rate of silicon nitride.

The membrane can be made of a monocrystalline silicon carbide to allow epitaxial growth on the membrane.

A monocrystalline material, also known as a single crystal, is a solid in which the crystal lattice of the entire sample is continuous and unbroken to the edges of the sample, with no grain boundaries. This means the crystal structure is uniform throughout the material.

Epitaxial growth refers to the process by which a crystalline thin film layer is grown on a crystalline substrate or membrane such that the grown thin film layer mimics the crystal structure and orientation of the underlying substrate. The atoms of the growing thin film layer may align themselves with the crystal lattice of the substrate, resulting in a coherent and defect-free interface. Epitaxy is a thin film layer deposition process where the deposited material has the same crystal orientation as the growth substrate.

This method is commonly used in the semiconductor industry to create highly ordered thin film layers for various electronic and optoelectronic applications. Reference is made to US 2010/0140497 A1.

The object of the invention is to provide a TEM grid with improved properties. In particular, it should be possible to realize high-quality electronic components on such TEM grid.

The object of the invention can be solved by a method comprising the features of appended claim 1. The object of the invention can be further solved by a TEM grid comprising the features of appended claim 14. The dependent claims refer to preferred embodiments of the invention.

The method of manufacturing a TEM grid comprises the step of creating a hole through a monocrystalline substrate. The hole can then lead from one front of the substrate to a back of the substrate.

The method of manufacturing a TEM grid comprises the step of attaching a monocrystalline membrane to the substrate. The membrane then covers the hole.

The substrate and the membrane are made of the same monocrystalline material.

Preferably, the crystal orientation of the substrate corresponds with the crystal orientation of the membrane. Crystal orientation refers to the arrangement and alignment of atoms in a crystal relative to a fixed coordinate system. Once the membrane has been attached to the substrate, the crystal orientations of the substrate and membrane are preferably the same or at least nearly the same. In this way, desired properties of the grid can be improved. In particular, epitaxial growth on the membrane can be improved.

A TEM grid produced in this way can consist of a monocrystalline material. Such a TEM grid can be very low-tension. This is beneficial for epitaxial growth on the membrane.

The shape of the hole can be arbitrary. A square or a round cross-section, for example, is possible. For example, the hole can be cylindrical or funnel-shaped.

The hole maybe drilled into a back surface of the substrate. The membrane maybe attached to the opposite front surface of the substrate. Properties of the TEM grid can thus be further improved. In particular, epitaxial growth on the membrane can be improved in this way.

The monocrystalline material can be Si or SrTiO₃. The monocrystalline material can be a perovskite. Other single-crystal materials are also possible. The TEM grid according to the present invention comprises a substrate and a membrane both made of monocrystalline SiTiO₃.

The thickness of the substrate can be at least 50 µm. The thickness of the substrate can be not more than 500 µm.

The thickness of the membrane can be at least 10 nm or at least 20 nm. The thickness of the membrane can be not more than 1 µm or not more than 500 nm. The thickness of the membrane can be particularly preferred 50 nm to 100 nm.

The diameter or width and length of the hole can be at least 1 µm or 10 µm. The diameter or width and length of the hole can be not more than 1 mm or not more than 5 mm.

Attaching the membrane to the substrate can be carried out by diffusion welding. In this way, a firm connection can be created between the substrate and the membrane.

Attaching the membrane to the substrate can be carried out by heating. The membrane is then first placed on the substrate or vice versa. After that, the membrane and substrate are heated. If the temperature is heated to a sufficiently high temperature, diffusion welding can take place. The temperature for heating can be more than 500 °C or more than 600 °C or more than 900°C. Temperatures of at least 500 °C or at least 600 °C or at least 900 °C can therefore be reached. The temperature for heating can be less than 1500 °C or less than 1200 °C.

Creating a hole in the substrate can be carried by etching. A mask can first be applied to a surface of the substrate. The etching rate of the mask is low compared to the etching rate of the substrate. A hole can be created in the mask, for example with the help of an ion beam. Through the hole of the mask, the hole in the substrate can then be created by etching.

The substrate can be composed of silicon. The mask can be composed of silicon nitride or silicon carbide. A hole can be etched into the substrate by means of KOH. After creating the hole, the mask can be removed by means of ion beams, for example.

The hole in the substrate can be milled using a laser beam or a focused ion beam. The surface of the substrate to be milled into can be polished prior to milling. This can improve milling.

The roughness of the surface to be milled into can be smaller than the wavelength of the laser light used for milling after polishing. This can improve milling with the help of a laser beam. The substrate can be composed of SrTiO₃. SrTiO₃ may be particularly suitable for epitaxial growth of high-temperature superconductors, for example, YBa₂Cu₃O₇₋ₓ.

One surface of the substrate can be polished. The membrane can be attached to this polished surface. The surface of the substrate can be epitaxy-ready polished. The roughness of the surface is then less than 1 nm. This can further improve desired properties of the TEM grid. In particular, epitaxial growth on the substrate beyond the membrane and diffusion welding of the membrane to the substrate can be improved.

The surface of the substrate to which the membrane will be attached can be polished smoother than the opposite surface of the substrate. With little technical effort, a TEM grid with particularly advantageous properties can be created.

A thin film layer can be epitaxially deposited on the membrane. This can be done to study epitaxial growth on the membrane. This can be done to produce an electronic component.

The temperature during the deposition of the layer can be at least 600 °C or at least 900 °C or at least 1000 °C. The layer can be deposited by chemical vapor deposition, evaporation, sputtering and laser ablation. The substrate can be very hot during deposition. There may be heating conductors, which can be made of platinum or molybdenum or tungsten, for example. With one or more heating conductors, the substrate and the membrane can be heated in order to be able to deposit an epitaxial thin film layer on the membrane in a suitable way.

With the help of an electron microscope, deposition process can be observed in real time. In this way, deposition can be analyzed. Deposition can be controlled with the help of observation.

In order to be able to observe temperature dependencies of a deposition, a very thin wire can be made on the membrane using electron beam lithography. The wire can have a diameter of down to a few nanometers. The wire can be heated with the help of electrical current. If a material is then deposited as a layer, different temperatures prevail depending on the distance to the wire. Thus, a temperature-dependent deposition can be observed. The wire can be made of a material with high melting point, such as platinum or molybdenum or tungsten, for example.

With the help of the invention, electronic components can be produced in very high quality by epitaxial deposition of one or more thin film layers on the membrane.

The material of the layer can be a high-temperature superconductor or ferromagnetic. The material of the layer can be YBa₂Cu₃O₇₋ₓ or SrRuO₃. X can be a number that is not greater than one. X can be greater than zero. X can be zero.

The membrane can be first deposited on a sacrificial layer of a further substrate. Thereafter, the sacrificial layer can be dissolved. With the help of the further substrate, the membrane can be transferred to the said substrate. After that, the desired TEM grid is available and can be used for deposing a thin film layer on the membrane.

The membrane can be prepared on a sacrificial layer and transferred to the said substrate as explained in document "Di Lu et al., Synthesis of freestanding single-crystal perovskite films and heterostructures by etching of sacrificial water-soluble layers, Nature Materials 15, 1255-1260 (2016)".

The membrane can be prepared on a sacrificial layer and transferred to the substrate by remote epitaxy. Further details are explained in document "Hyunseok Kim et al., Remote epitaxy, NATURE REVIEWS | METHODS PRIMERS | Article citation ID: (2022) 2:40".

The surface of the sacrificial layer on which the membrane is located can be epitaxially grown. This can help creating a grid with desired monocrystalline properties.

The sacrificial layer can be made of a water-soluble material. It is then advantageous to dissolve the sacrificial layer with the help of water.

It is possible that the sacrificial layer has been epitaxially deposited on the further substrate. After that, the membrane may have grown epitaxially on the sacrificial layer. This may have created a membrane with particularly good monocrystalline properties.

First, the substrate can be given the desired shape, for example cylindrical, using ultrasonic drilling or a ceramic milling device. Thinning and polishing can be carried out using sandpaper, a special polishing cloth with a polishing paste or an ion beam.

An example of the invention is also explained below using figures.
Figure 1 shows a cross section of a TEM grid and an enlarged section of it.
Figure 2 shows a cross section of a further substrate with sacrificial layers and a membrane.

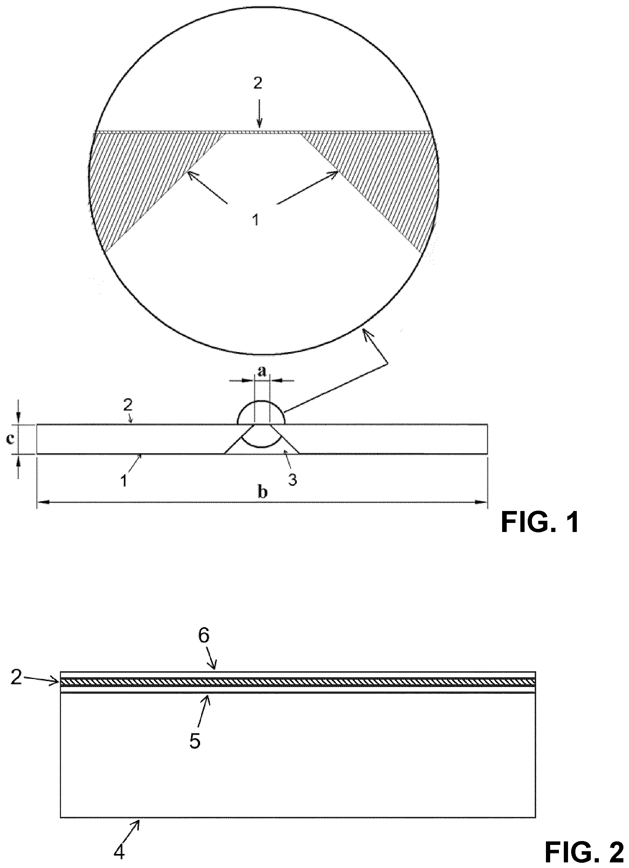

Figure 1 shows a cross section of a TEM grid and an enlarged section of it. For example, the TEM grid of Fig. 1 can be made from a single-crystal SrTiO₃ substrate 1 and a single-crystal SrTiO₃ membrane 2. SrTiO₃ is the most suitable substrate material for the deposition of epitaxial layers which may formed from the high-temperature superconductor YBa₂Cu₃O₇₋ₓ (T_{Curie} = 92 K) and the ferromagnetic SrRuO₃ (T_{Curie} = 160 K). These materials all have a similar lattice constant of about 0.39 nm. If materials have similar lattice constants, electronic components of particularly good quality can be produced by epitaxial growth of layers.

The substrate 1 can first be formed into the shape of a 200 µm thick disc (c = 200 µm) with a diameter of 3 mm (b = 3 mm). These are standard outer dimensions of a TEM grid. Both sides of the substrate 1 can be polished first as explained above. With the help of plasma-focused ion beam etching, a hole 3 with a minimum diameter of about 20 µm can be drilled in the center of the disk (a = 20 µm). The hole 3 can widen towards the back, as shown in Figure 1, that is advantageous for preparation of the hole and for observation in TEM under small tilt angles. The thickness of the substrate 1 can be 200 µm (c = 200 µm). The thickness of the membrane 2 can be 100 nm.

Figure 2 shows a cross section of a further substrate 4 with sacrificial thin-film layers 5, 6 and the membrane 2. An epitaxial single-crystal SrTiO₃ membrane 2 can be deposited on the further substrate 4, which may be covered with an epitaxial first sacrificial thin-film layer 5. The membrane 2 can then be grown on the first sacrificial layer 5.

An additional second sacrificial layer 6, for example formed from a polymer, can be applied to the SrTiO₃ membrane 2 for protective reasons. The second sacrificial layer 6 can be used to stabilize the SrTiO₃ membrane 2 during the transfer from the further substrate 4 to the SrTiO₃ substrate 1 using a holder (not shown in Fig.2) that is attached above the second sacrificial layer 6.

The first sacrificial layer 5 can be dissolved. The membrane 2 with the second sacrificial layer 6 can be placed on top of the SrTiO₃ substrate 1. The second sacrificial layer 6 can then be dissolved to release the membrane 2 from the holder. After removal of the second sacrificial layer 6, the epitaxial single-crystal SrTiO3 membrane 2 transmitted in this way can initially be held on the SrTiO₃ substrate 1 by van der Waals forces. The SrTiO₃ substrate 1 with the membrane 2 can then be heated in air to a temperature of 1000 °C to remove organic residues and improve adhesion between the membrane 2 and the substrate 1 through mutual diffusion of atoms at the interface (diffusion welding). Ideally, such a homoepitaxial substrate-membrane arrangement can be obtained. In this way, a homoepitaxial TEM grid with low tension can be created.

## Claims

1. Method of manufacturing a TEM grid comprising the steps of:
creating a hole (3) through a monocrystalline substrate (1),
attaching a monocrystalline membrane (2) to the substrate (1) with the hole, the membrane covering the hole,
wherein the substrate (1) and the membrane (2) are made of the same monocrystalline material.

2. Method according to the preceding claim, wherein the hole is drilled into a back surface of the substrate (1) and the membrane (2) is attached to the opposite front surface of the substrate (1).

3. Method according to one of the preceding claims, wherein the monocrystalline material is Si or SrTiO₃.

4. Method according to one of the preceding claims, wherein the thickness of the substrate (1) is at least 100 µm and not more than 500 µm.

5. Method according to one of the preceding claims, wherein the thickness of the membrane (2) is at least 10 nm and not more than 1 µm.

6. Method according to one of the preceding claims, wherein the diameter of the hole (3) is at least 1 µm and not more than 5 mm.

7. Method according to one of the preceding claims, wherein attaching the membrane (2) to the substrate (1) is carried out by diffusion welding.

8. Method according to one of the preceding claims, wherein milling the hole in the substrate is carried out with the help of a laser beam or a focused ion beam.

9. Method according to the preceding claim, wherein the surface of the substrate to be milled into is polished prior to milling.

10. Method according to the preceding claim, wherein the roughness of the surface to be milled is less than the wavelength of a laser light used to mill after polishing.

11. Method according to one of the preceding claims, wherein one surface of the substrate (1) is polished and the membrane (2) will be attached to this polished surface.

12. Method according to the preceding claim, **characterized in that** the roughness of the surface after polishing is less than 1 nm.

13. Method according to any of the preceding claims, **characterized in that** a layer is epitaxially deposited on the membrane (2).

14. TEM grid comprising a monocrystalline substrate (1) with a hole and a monocrystalline membrane (2) which is attached to the substrate (1) and which covers said hole, wherein the substrate (1) and the membrane (2) are made of the same monocrystalline material, wherein the monocrystalline material is SrTiO₃.

15. TEM grid according to the preceding claim, wherein the crystal orientation of the substrate (1) corresponds with the crystal orientation of the membrane (2).

## Patentansprüche

1. Verfahren zur Herstellung eines TEM-Gitters, umfassend die Schritte:
Erzeugen eines Lochs (3) durch ein monokristallines Substrat (1),
Anbringen einer monokristallinen Membran (2) an dem Substrat (1) mit dem Loch, wobei die Membran das Loch bedeckt,
wobei das Substrat (1) und die Membran (2) aus demselben monokristallinen Material hergestellt sind.

2. Verfahren nach dem vorhergehenden Anspruch, wobei das Loch in eine Rückfläche des Substrats (1) gebohrt wird und die Membran (2) an der gegenüberliegenden Vorderfläche des Substrats (1) angebracht wird.

3. Verfahren nach einem der vorhergehenden Ansprüche, wobei das monokristalline Material Si oder SrTiO₃ ist.

4. Verfahren nach einem der vorhergehenden Ansprüche, wobei die Dicke des Substrats (1) mindestens 100 µm und nicht mehr als 500 µm beträgt.

5. Verfahren nach einem der vorhergehenden Ansprüche, wobei die Dicke der Membran (2) mindestens 10 nm und nicht mehr als 1 µm beträgt.

6. Verfahren nach einem der vorhergehenden Ansprüche, wobei der Durchmesser des Lochs (3) mindestens 1 µm und nicht mehr als 5 mm beträgt.

7. Verfahren nach einem der vorhergehenden Ansprüche, wobei das Anbringen der Membran (2) an dem Substrat (1) durch Diffusionsschweißen durchgeführt wird.

8. Verfahren nach einem der vorhergehenden Ansprüche, wobei das Fräsen des Lochs in dem Substrat mit Hilfe eines Laserstrahls oder eines fokussierten Ionenstrahls durchgeführt wird.

9. Verfahren nach dem vorhergehenden Anspruch, wobei die Oberfläche des Substrats, in die gefräst werden soll, vor dem Fräsen poliert wird.

10. Verfahren nach dem vorhergehenden Anspruch, wobei die Rauheit der zu fräsenden Oberfläche nach dem Polieren geringer ist als die Wellenlänge eines zum Fräsen verwendeten Laserlichts.

11. Verfahren nach einem der vorhergehenden Ansprüche, wobei eine Oberfläche des Substrats (1) poliert wird und die Membran (2) an dieser polierten Oberfläche angebracht wird.

12. Verfahren nach dem vorhergehenden Anspruch, **dadurch gekennzeichnet, dass** die Rauheit der Oberfläche nach dem Polieren weniger als 1 nm beträgt.

13. Verfahren nach einem der vorhergehenden Ansprüche, **dadurch gekennzeichnet, dass** eine Schicht epitaktisch auf der Membran (2) abgeschieden wird.

14. TEM-Gitter, umfassend ein monokristallines Substrat (1) mit einem Loch und eine monokristalline Membran (2), die an dem Substrat (1) angebracht ist und die das Loch bedeckt, wobei das Substrat (1) und die Membran (2) aus demselben monokristallinen Material hergestellt sind, wobei das monokristalline Material SrTiO₃ ist.

15. TEM-Gitter nach dem vorhergehenden Anspruch, wobei die Kristallorientierung des Substrats (1) mit der Kristallorientierung der Membran (2) übereinstimmt.

## Revendications

1. Procédé de fabrication d'une grille pour microscope électronique à transmission (MET), comprenant les étapes suivantes:
réaliser d'un trou (3) à travers un substrat monocristallin (1),
fixer une membrane monocristalline (2) sur le substrat (1) comportant le trou, la membrane recouvrant le trou,
dans lequel le substrat (1) et la membrane (2) sont constitués du même matériau monocristallin.

2. Procédé selon la revendication précédente, dans lequel le trou est percé dans une face arrière du substrat (1) et la membrane (2) est fixée à la face avant opposée du substrat (1).

3. Procédé selon l'une des revendications précédentes, dans lequel le matériau monocristallin est du Si ou du SrTiO₃.

4. Procédé selon l'une des revendications précédentes, dans lequel l'épaisseur du substrat (1) est au moins 100 µm et ne plus que 500 µm.

5. Procédé selon l'une des revendications précédentes, dans lequel l'épaisseur de la membrane (2) est au moins 10 nm et ne plus que 1 µm.

6. Procédé selon l'une des revendications précédentes, dans lequel le diamètre du trou (3) est au moins 1 µm et ne plus que 5 mm.

7. Procédé selon l'une des revendications précédentes, dans lequel la fixation de la membrane (2) sur le substrat (1) est réalisée par soudage par diffusion.

8. Procédé selon l'une des revendications précédentes, dans lequel le fraisage du trou dans le substrat est réalisé à l'aide d'un faisceau laser ou d'un faisceau d'ions focalisé.

9. Procédé selon la revendication précédente, dans lequel la surface du substrat à fraiser est polie avant le fraisage.

10. Procédé selon la revendication précédente, dans lequel la rugosité de la surface à fraiser est inférieure à la longueur d'onde d'une lumière laser utilisée pour le fraisage après polissage.

11. Procédé selon l'une des revendications précédentes, dans lequel une surface du substrat (1) est polie et la membrane (2) est fixée à cette surface polie.

12. Procédé selon la revendication précédente, **caractérisé en ce que** la rugosité de la surface après polissage est inférieure à 1 nm.

13. Procédé selon l'une quelconque des revendications précédentes, **caractérisé en ce qu'**une couche est déposée par épitaxie sur la membrane (2).

14. Grille TEM comprenant un substrat monocristallin (1) percé d'un trou et une membrane monocristalline (2) qui est fixée au substrat (1) et qui recouvre ledit trou, dans laquelle le substrat (1) et la membrane (2) sont constitués du même matériau monocristallin, ledit matériau monocristallin étant du SrTiO₃.

15. Grille TEM selon la revendication précédente, dans laquelle l'orientation cristalline du substrat (1) correspond à l'orientation cristalline de la membrane (2).
